# EUROPÄISCHE PATENTANMELDUNG

(11) **EP 2 363 631 A2**
(43) Veröffentlichungstag der Anmeldung: **07.09.2011**
(21) Anmeldenummer: 11000440.5
(22) Anmeldetag: 20.01.2011
(51) Int. Cl.: F21S 2/00, F21Y 101/02

(54) **Modulares Beleuchtungssystem mit einer Vielzahl von Beleuchtungsmodulen**

(30) Priorität: 05.03.2010 DE 102010010343
(71) Anmelder: benwirth licht e.K., 80636 München (DE)
(72) Erfinder: Wirth, Ben, 80636 München (DE)
(74) Vertreter: Vossius, Corinna

(57) **Zusammenfassung**

Die Erfindung stellt ein modulares Beleuchtungssystem (60) bereit. Das modulare Beleuchtungssystem umfasst eine Vielzahl von Beleuchtungsmodulen (10a,10b,10c), die jeweils eine Trägerplatte bzw. Trägerplatine sowie wenigstens eine erste Schnittstelle zur Strom- und Signalleitung umfassen, die vorzugsweise an der Trägerplatte angebracht ist. Das modulare Beleuchtungssystem umfasst ferner eine Vielzahl von länglichen Verbindungselementen, die an ihren jeweiligen Enden eine zweite Schnittstelle umfassen. Dabei lassen sich die zwei zweiten Schnittstellen an den jeweiligen Enden eines Verbindungselements derart mit den jeweiligen ersten Schnittstellen von zwei Beleuchtungsmodulen verbinden, dass eine Strom- und Signalleitung zwischen den durch ein Verbindungselement miteinander verbundenen Beleuchtungsmodulen ausgebildet wird. Wenigstens ein Beleuchtungsmodul ist mit Leuchtmitteln (14a,14b,14c) versehen, die vorzugsweise an der Trägerplatte des Beleuchtungsmoduls angebracht sind.

## Beschreibung

### GEBIET DER ERFINDUNG

Die Erfindung betrifft ein modulares Beleuchtungssystem mit einer Vielzahl von mit Leuchtmitteln versehenen Beleuchtungsmodulen.

### HINTERGRUND DER ERFINDUNG

Es sind Beleuchtungssysteme bekannt, die mehrere Leuchtmittel, beispielsweise LED, aufweisen, die verschiebbar an einer Trägerschiene oder mehreren Trägerschienen bzw. Trägerseilen angebracht sind. Zur Montage dieser bekannten Beleuchtungssysteme können die Trägerschienen an der Decke eines Raumes befestigt werden. Die Stromversorgung und die Ansteuerung der Leuchtmittel des Beleuchtungssystems erfolgt dabei oftmals über ein Kabel, das entlang der oder durch die Trägerschienen hindurch geführt ist. Bei derartigen Beleuchtungssystemen ist die Wahl der Positionen der Leuchtmittel im Wesentlichen durch die Form und die Anordnung der Trägerschienen beschränkt. Ferner sind derartige Beleuchtungssysteme aufgrund der Stromversorgung über ein Kabel insofern beschränkt, als sich nur die Helligkeit aller LED eines Beleuchtungssystems gleichzeitig ändern lässt.

Die Aufgabe der vorliegenden Erfindung besteht darin, ein verbessertes Beleuchtungssystem bereitzustellen, das insbesondere die vorstehenden Nachteile nicht aufweist.

### ZUSAMMENFASSUNG DER ERFINDUNG

Die vorstehende Aufgabe wird durch ein modulares Beleuchtungssystem gemäß Anspruch 1 gelöst. Das modulare Beleuchtungssystem umfasst eine Vielzahl von Beleuchtungsmodulen, die jeweils eine Trägerplatte bzw. Trägerplatine sowie wenigstens eine erste Schnittstelle zur Strom- und Signalleitung umfassen, die vorzugsweise an der Trägerplatte angebracht ist. Das modulare Beleuchtungssystem umfasst ferner eine Vielzahl von länglichen Verbindungselementen, die an ihren jeweiligen Enden eine zweite Schnittstelle umfassen. Dabei lassen sich die zwei zweiten Schnittstellen an den jeweiligen Enden eines Verbindungselements derart mit den jeweiligen ersten Schnittstellen von zwei Beleuchtungsmodulen verbinden, dass eine Strom- und Signalleitung zwischen den durch ein Verbindungselement miteinander verbundenen Beleuchtungsmodulen ausgebildet wird. Wenigstens ein Beleuchtungsmodul ist mit Leuchtmitteln versehen, die vorzugsweise an der Trägerplatte des Beleuchtungsmoduls angebracht sind.

Bei dem erfindungsgemäßen Beleuchtungssystem können somit die Beleuchtungsmodule mittels der Verbindungselemente im Baukastenprinzip lösbar derart miteinander verbunden werden, dass eine Struktur ausgebildet wird, die eine Vielzahl von Beleuchtungsmodulen mit Leuchtmitteln umfasst. Dabei erfolgt die Verbindung zwischen jeweils zwei Beleuchtungsmodulen über jeweils ein Verbindungselement derart, dass Steuerungsdaten und ein elektrischer Strom zwischen diesen derart miteinander verbundenen Beleuchtungsmodulen fließen kann.

Eine separate Trägerstruktur oder ein separates Gehäuse ist erfindungsgemäß nicht erforderlich, da die mittels der Verbindungselemente lösbar miteinander verbundenen Beleuchtungsmodule eine im Wesentlichen formstabile Einheit ausbilden, die je nach Anwendung lediglich an einer Decke bzw. Wand eines Raums fixiert werden muss.

Indem sich das erfindungsgemäße Beleuchtungssystem nach dem Baustein- bzw. Baukastenprinzip aus standardisierten Beleuchtungsmodulen zusammensetzt, kann das Beleuchtungssystem beliebig verändert werden, insbesondere problemlos an unterschiedliche Raum- und Größenverhältnisse angepasst werden. Insbesondere lassen sich die einzelnen Beleuchtungsmodule und Verbindungselemente in unterschiedlicher Art und Weise zu einem Beleuchtungssystem kombinieren. Beispielsweise kann das erfindungsgemäße Beleuchtungssystem je nach den räumlichen Anforderungen erweitert, verkleinert und/oder neu positionieren werden. Daraus ergeben sich vielfältige Einsatzmöglichkeiten für das erfindungsgemäße Beleuchtungssystem, insbesondere als Wandleuchte und Deckenleuchte.

Vorzugsweise erfolgt die Berestigung eines erfindungsgemäßen Beleuchtungssystems an der Decke eines Raumes dadurch, dass einige tragend angeordnete Beleuchtungsmodule des Beleuchtungssystems mit Befestigungsmitteln versehen sind, die eine Befestigung an der Decke ermöglichen. Hierzu sind vorzugsweise wenigstens einige der Beleuchtungsmodule derart magnetisch ausgestaltet, was es erlaubt diese Beleuchtungsmodule an entsprechenden Stellen der Decke über dort angebrachte Schrauben zu befestigen und somit das gesamte Beleuchtungssystem an der Decke anzubringen.

Vorzugsweise sind die Trägerplatten der Beleuchtungsmodule im Wesentlichen eben. Dabei ist die Form der Trägerplatten der Beleuchtungsmodule vorzugsweise dreieckig, viereckig, sechseckig und/oder achteckig, so dass die Trägerplatten drei, vier, sechs bzw. acht Seiten aufweisen. Vorzugsweise weist jede Trägerplatte genauso viele erste Schnittstellen wie Seiten auf. Beispielsweise umfasst eine bevorzugte achteckige Trägerplatte mit acht Seiten acht erste Schnittstellen auf, die vorzugsweise entlang der acht Seiten der achteckigen Trägerplatte angeordnet sind.

Der Aufbau des erfindungsgemäßen Beleuchtungssystems aus standardisierten Beleuchtungsmodulen und Verbindungselementen im Baukastenprinzip reduziert die Herstellungskosten und vereinfacht die Montage sowie die Reparatur fehlerhafter Komponenten.

Als Leuchtmittel, die als Teil eines Beleuchtungsmoduls eingesetzt werden können, kommen im Prinzip sämtliche elektrischen Betriebsmittel in Betracht, die dazu dienen, Licht zu erzeugen, wie beispielsweise Halogen, LED, OLED, CCFL und dergleichen. Neben den traditionellen elektrischen Leuchtmitteln kommen somit auch moderne Leuchteelemente, vorzugsweise Leuchtdioden (LED) zum Einsatz.

Das erfindungsgemäße Beleuchtungssystem umfasst vorzugsweise ferner eine Steuereinheit, die es ermöglicht, die Leuchtmittel der Beleuchtungsmodule des Beleuchtungssystems anzusteuern. Dabei ist die Steuereinheit derart ausgestaltet und die Verbindungselemente, die die Beleuchtungsmodule miteinander verbinden, sind derart konfiguriert, dass die Steuereinheit die Leuchtmittel einzelner Beleuchtungsmodule, einer Untermenge der Beleuchtungsmodule und/oder aller Beleuchtungsmodule ansteuern kann, d.h. beispielsweise an- und ausschalten, die Lichtstärke steigern oder senken und dergleichen. Das "Abdimmen" und/oder andere Funktionen der Leuchtmittel eines Beleuchtungsmoduls können zusätzlich oder alternativ dadurch erfolgen, dass eine bestimmte Stelle des Beleuchtungsmoduls berührt wird, an der ein Sensor vorgesehen ist, der in Reaktion auf die Berührung die gewünschte Funktion durchführt, beispielsweise das Leuchtmittel des betreffenden Beleuchtungsmoduls abdimmt. Mit anderen Worten: einige der Beleuchtungsmodule können derart ausgestaltet sein, dass diese ermöglichen, bestimmte Steuerfunktionen der Steuereinheit auszulösen. Das erfindungsgemäße Beleuchtungssystem kann jedoch selbstverständlich auch zusätzlich oder alternativ über einen herkömmlichen Drehschalter betätigt werden.

Die Fähigkeit der Steuereinheit, einzelne Beleuchtungsmodule direkt anzusteuern, ist insbesondere bei der Verwendung von Beleuchtungsmodulen interessant, die Licht mit unterschiedlichen Farben aussenden (beispielsweise RGB-Beleuchtungsmodule). Dabei ermöglicht die Steuereinheit eine frei konfigurierbare Beleuchtungssituation, die sich dem Benutzer und den äußeren Bedingungen, beispielsweise dem Tageslicht, anpasst. Die Beleuchtungssituation könnte sich auch der Bewegung bzw. dem Aufenthaltsort des Benutzers anpassen. Hierzu kann das erfindungsgemäße Beleuchtungssystem entsprechende Sensoren zur Erfassung von Bewegungen umfassen.

Die Steuereinheit kann beispielsweise als Bus-System, insbesondere als ein Feld-Bus-System ausgestaltet sein. Diese Art der Vernetzung der Beleuchtungsmodule des Beleuchtungssystems ist kostengünstig und zuverlässig. Die Feld-Bus-Vernetzung bietet darüber hinaus die einfache Möglichkeit von Erweiterungen des Beleuchtungssystems durch Hinzufügung weiterer Beleuchtungsmodule und ggf. Verbindungselemente, die an das Bus-System problemlos anschließbar sind. Vorzugsweise werden über ein Bus-System nicht nur Steuerungsinformationen über die Verbindungselemente an die Beleuchtungsmodule übertragen, sondern es wird darüber hinaus die Energie- bzw. Stromversorgung der einzelnen Beleuchtungsmodule sichergestellt. Für die Anbindung in ein eventuell vorhandenes Hausbussystem, wie z.B. Insta-Bus oder DALI, können auch Gateways eingesetzt werden.

Sofern die Steuereinheit eine externe Schnittstelle aufweist, können an das erfindungsgemäße Beleuchtungssystem externe Geräte, wie beispielsweise eine Audioquelle, angeschlossen oder das Beleuchtungssystem in Kommunikationsnetzwerke, wie beispielsweise ein LAN und/oder das Internet, eingebunden werden, so dass die Steuerung des erfindungsgemäßen Beleuchtungssystems beispielsweise über einen Computer eines LANs erfolgen kann.

Erfindungsgemäß ist es möglich, dass einige Beleuchtungsmodule keine Leuchtmittel aufweisen und lediglich als Platzhalter, mechanisches Bindeglied und Verteiler für einen Strom und/oder elektrische Steuersignale zu benachbarten Beleuchtungsmodulen dienen.

Vorzugsweise kann ein Beleuchtungsmodul ferner wenigstens eines der folgenden Elemente umfassen: Sensoren, die z.B. Bewegungen, Lichtverhältnisse oder Schall wahrnehmen; Empfänger für z.B. Funk- oder Infrarotfernbedienungen; mechanisch verstellbare Spiegel, die z. B. als Lichtverteilsystem für Tageslicht dienen; Displays; Firmenlogos; Sprachaufzeichnungsmodule und/oder Lautsprecher zur Wiedergabe von Audio-Informationen.

Weitere bevorzugte und vorteilhafte Ausführungsformen sind in den Unteransprüchen definiert oder ergeben sich anhand der nachstehenden detaillierten Beschreibung eines bevorzugten Ausführungsbeispiels im Zusammenhang mit den anhängenden Zeichnungen.

### KURZE BESCHREIBUNG DER ZEICHNUNGEN

Die Figuren 1a und 1b zeigen perspektivische Ansichten der Unterseite bzw. der Oberseite eines bevorzugten Beleuchtungsmoduls eines erfindungsgemäßen Beleuchtungssystems.
Figur 2 zeigt eine perspektivische Ansicht einer Vielzahl von bevorzugten Verbindungselementen eines erfindungsgemäßen Beleuchtungssystems.
Figur 3 zeigt eine perspektivische Ansicht einer ersten Ausführungsform eines erfindungsgemäßen Beleuchtungssystems.
Figur 4 zeigt eine perspektivische Ansicht einer zweiten Ausführungsform eines erfindungsgemäßen Beleuchtungssystems.

Die Figuren 5a und 5b zeigen eine perspektivische Ansicht sowie eine Detailansicht eines Ausschnitts einer dritten Ausführungsform eines erfindungsgemäßen Beleuchtungssystems.

### DETAILLIERTE BESCHREIBUNG BEVORZUGTER AUSFÜHRUNGSFORMEN

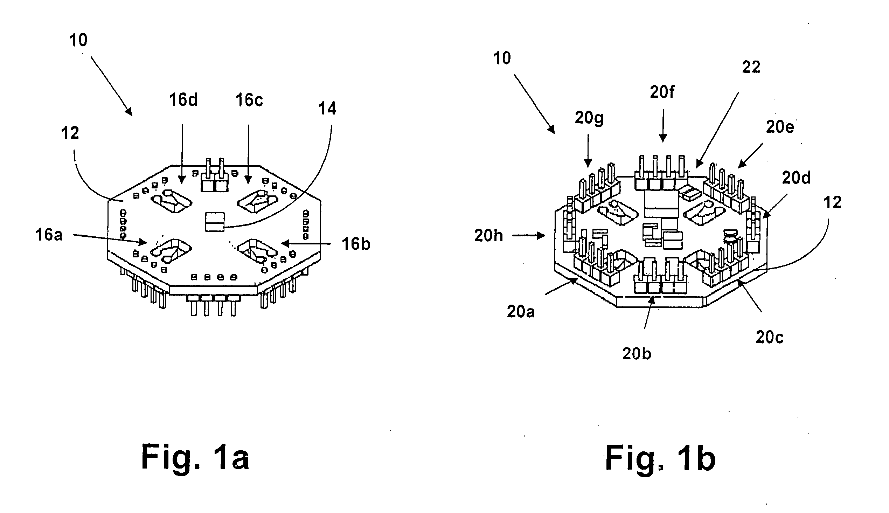

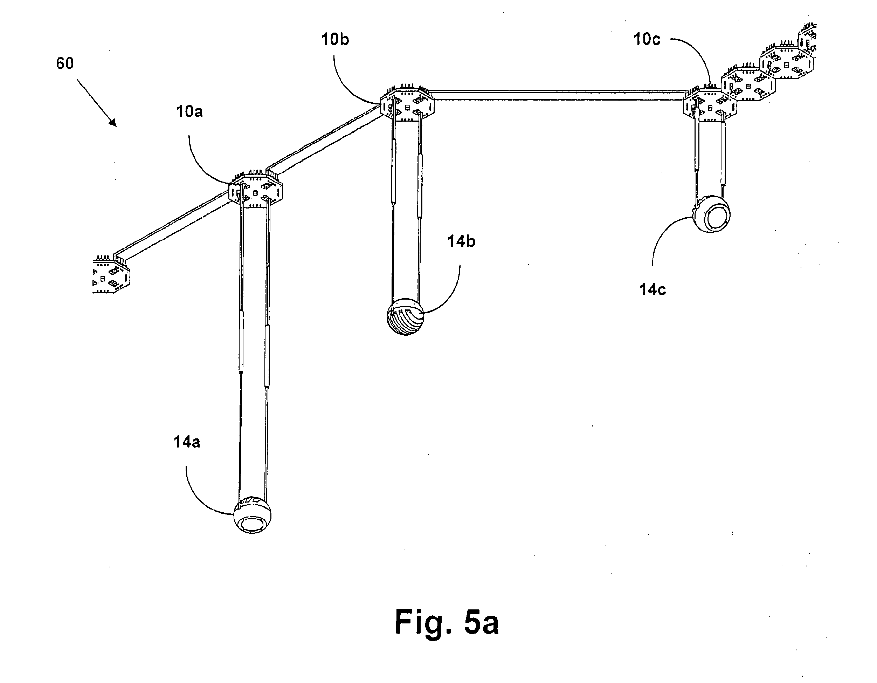

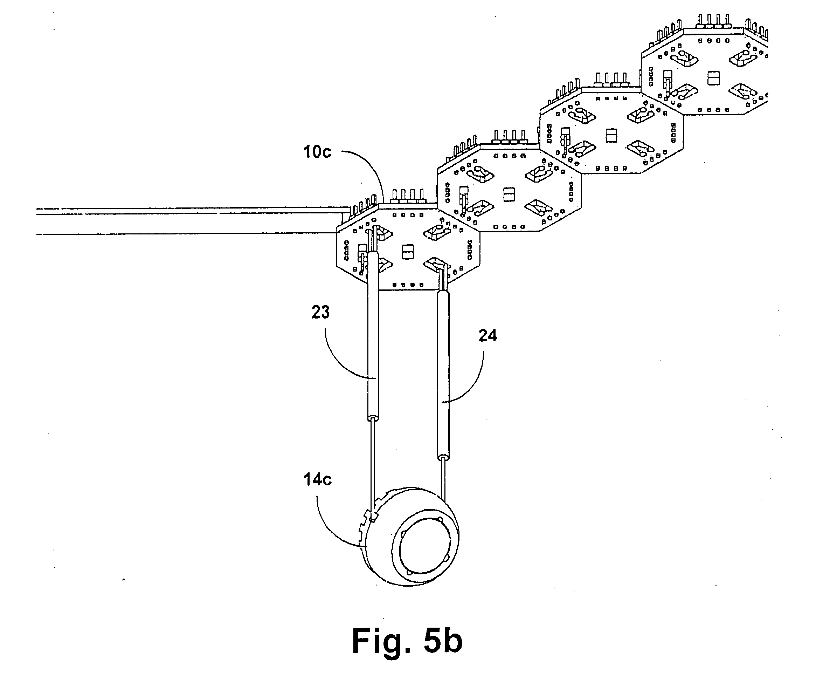

Die Figuren 1a und 1b zeigen perspektivische Ansichten eines Beleuchtungsmoduls 10 gemäß einer ersten bevorzugten Ausführungsform von vorne bzw. hinten. Das Beleuchtungsmodul 10 besteht im Wesentlichen aus einer ebenen Trägeplatte bzw. Trägerplatine 12, die die Form eines regelmäßigen Achtecks aufweist. Auf der in Figur 1a dargestellten Unterseite der Trägerplatte 12 befindet sich in der Mitte der Trägerplatte 12 ein Leuchtmittel 14 in Form einer LED. Um die zentral angeordnete LED 14 herum sind vier Aussparungen 16a-d in der Trägerplatte 12 definiert, die durch die Trägerplatte 12 hindurchgehen und deren Funktion im Zusammenhang mit der in den Figuren 5a und 5b dargestellten Ausführungsform nachstehend detaillierter beschrieben wird.

Dem Fachmann ist wohl bekannt, dass es sich bei einer Leuchtdiode (auch *Lumineszenz-Diode,* kurz LED für *Light Emitting Diode* beziehungsweise *lichtemittierende Diode*) um ein elektronisches Halbleiter-Bauelement handelt. Durch eine geeignete Wahl des Halbleitermaterials mit passender Dotierung ist es möglich, LED zu erhalten, die Licht in den unterschiedlichsten Farben aussenden. Selbstverständlich umfasst die Erfindung auch Beleuchtungsmodule 10 mit mehr als einer LED, beispielsweise mit zwei oder vier LED. Ebenso können die LED an anderen Stellen als im Zentrum der Trägerplatte 12 angeordnet sein. Ferner können anstatt oder zusätzlich zu einer oder mehreren LED auch andere Leuchtmittel eingesetzt werden. Beispielsweise könnte statt einer LED eine organische Leuchtdiode auf der Trägerplatte 12 angebracht sein. Eine Organische Leuchtdiode, kurz OLED (Kurzform für engl.: "organic light emitting diode"), ist ein dünnes, filmartiges, leuchtendes Bauelement aus organischen, halbleitenden Materialien, das sich von den anorganischen Leuchtdioden (LED) dadurch unterscheidet, dass Stromdichte und Leuchtdichte geringer sind und keine einkristallinen Materialien erforderlich sind. Ebenso ist es möglich, dass einige Beieuchtungsmodule eines erfindungsgemäßen Beleuchtungssystems keine Leuchtmittel aufweisen und lediglich als Knotenpunkt und Verteiler von Strom und Steuersignalen an benachbarte Beleuchtungsmodule dienen.

Auf der in Figur 1b dargestellten Oberseite der Trägerplatte 12, d.h. der Seite der Trägerplatte 12, die im installierten Zustand der Decke oder Wand eines Raumes zugewandt ist, umfasst das Beleuchtungsmodul 10 insgesamt acht Schnittstellen in Form von jeweils 4-poligen Kontaktstiftleisten- bzw. "Pin-Header"-Steckern 20a-h. Wie sich dies der Figur 1b entnehmen lässt, sind diese acht 4-poligen Pin-Header-Stecker 20a-h mit Ihrer Längsachse entlang der Umfangsseiten der achteckigen Trägerplatte 12 angeordnet. Ferner sind auf der Oberseite der Trägerplatte 12 mehrere Bauteile, beispielsweise ein LED-Treiber zur Versorgung der LED mit einem geeigneten Strom sowie eine Empfangseinheit zum Empfang von Steuersignalen und zur Weiterleitung dieser Steuersignale an den LED-Treiber, angeordnet, die Teil der Leistungselektronik des Beleuchtungsmoduls 10 sind, die in Figur 1b allgemein mit der Bezugsziffer 22 gekennzeichnet ist. Derartige Bauteile sind dem Fachmann wohlbekannt und werden daher hier nicht näher beschrieben. Wesentlich ist lediglich, dass die Leistungselektronik 22 eines Beleuchtungsmoduls 10 dafür sorgt, dass die Leuchtmittel 14 eines Beleuchtungsmoduls 10 mit Strom und Steuersignalen versorgt werden und dass die acht Schnittstellen 20a-h eines Beleuchtungsmoduls 10 miteinander kommunizieren können, d.h. Strom und Steuersignale von einer der acht Schnittstellen 20a-h zu jeder anderen der acht Schnittstellen übertragen werden können.

Vorzugsweise weist die achteckige Trägerplatte bzw. Trägerplatine 12 eine Seitenlänge von ca. 1 bis 2 cm auf. Der Fachmann wird erkennen, dass es sich bei der im Wesentlichen achteckigen Form der Trägerplatte 12 des Beleuchtungsmoduls 10 um eine bevorzugte Ausführungsform handelt. Es ist ebenso denkbar, dass die Trägerplatte eines erfindungsgemäßen Beleuchtungssystems die Form eines Dreiecks, Vierecks oder Sechsecks aufweist. Ebenso sind kreisförmige und/oder halbkreisförmige Trägerplatten mit entsprechend geformten Schnittstellen denkbar, die entlang des Umfangs der Trägerplatten angeordnet sind. Ferner ist es denkbar, dass in einem erfindungsgemäßen Beleuchtungssystem Beleuchtungsmodule mit unterschiedlichen Formen zum Einsatz kommen, zum Beispiel könnte ein erfindungsgemäßes Beleuchtungssystem unter anderem sowohl Beleuchtungsmodule mit dreieckigen Trägerplatten als auch Beleuchtungsmodule mit sechseckigen Trägerplatten aufweisen.

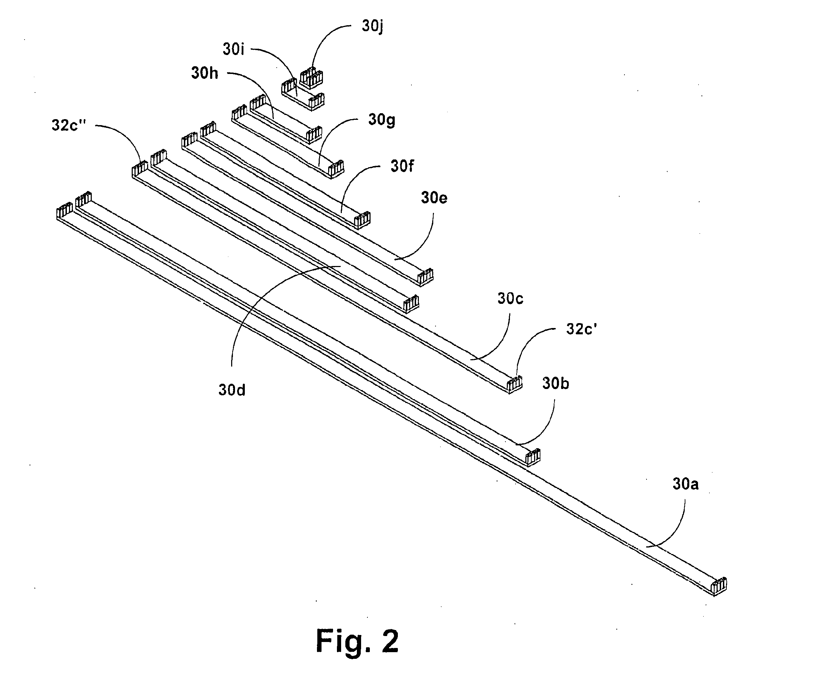

In der Figur 2 sind mehrere Verbindungselemente 30a-j mit unterschiedlichen Längen dargestellt, die dazu geeignet sind, mehrere der in den Figuren 1a und 1b dargestellten Beleuchtungsmodule 10 in den unterschiedlichsten Anordnungen zu einem erfindungsgemäßen Beleuchtungssystem miteinander zu verbinden. In Figur 2 sind beispielhaft zehn Verbindungselemente 30a-j mit unterschiedlichen Längen dargestellt, wobei das Verbindungselement 30a die größte Länge aufweist und das Verbindungselement 30j die kleinste Länge aufweist. Die Verbindungselemente 30a-j weisen jeweils an ihren beiden Enden eine Schnittstelle auf (beispielsweise die Schnittstellen 32c' und 32c" des Verbindungselements 30c). Diese Schnittstellen sind jeweils dazu ausgestaltet, beispielsweise mit einer der Schnittstellen 20a-h des in den Figuren 1a und 1b dargestellten Beleuchtungsmoduls 10 derart verbunden zu werden, dass entlang der Verbindung dieser beiden Schnittstellen ein Strom fließen kann und Steuersignale weitergeleitet werden können. Bei den Schnittstellen der in den Figur 2 dargestellten Verbindungselemente handelt es sich um 4-polige Steckleisten bzw. Kontaktbuchsen, die dazu ausgestaltet sind, die ebenfalls 4-poligen Kontaktstiftleisten- bzw. "Pin-Header"-Stecker 20a-h des in den Figuren 1a und 1b dargestellten Beleuchtungsmoduls 10 aufzunehmen. Dabei dienen vorzugsweise zwei der Kontaktstifte bzw. Pin-Header der Kontaktstiftleisten- bzw. "Pin-Header"-Stecker 20a-h zur Stromübertragung und die anderen beiden Kontaktstifte zur Übertragung von Steuersignalen. Selbstverständlich können auch mehr als 4 oder weniger als 4 Kontaktstifte vorgesehen sein. Vorzugsweise bestehen die länglichen Verbindungselemente 30a-j aus demselben Material wie die Trägerplatten bzw. Trägerplatinen 12 der Beleuchtungsmodule 10.

Der Fachmann wird erkennen, dass ein erfindungsgemäßes Beleuchtungssystem eine Vielzahl von Verbindungselementen mit nur einer Länge oder eine Vielzahl von Verbindungselementen mit unterschiedlichen Längen aufweisen kann. Beispielsweise könnte ein erfindungsgemäßes Beleuchtungssystem eine Vielzahl der in Figur 2 dargestellten Verbindungselemente 30j, eine Vielzahl der in Figur 2 dargestellten Verbindungselemente 30g sowie eine Vielzahl der in Figur 2 dargestellten Verbindungselemente 30f aufweisen. Vorzugsweise ist dabei die jeweilige Länge der in Figur 2 dargestellten Verbindungselemente 30j derart, dass die Seiten von zwei über diese Verbindungselemente 30j miteinander verbundenen Beleuchtungsmodulen aneinander anstoßen, und/oder sich die Länge eines Verbindungselements 30g zu der Länge eines Verbindungselements 30f wie 1/√2 verhält, d.h. ca. 1/1.414. Wie der Fachmann erkennt, erlaubt ein derartiges Längenverhältnis der Verbindungselemente die Ausbildung von erfindungsgemäßen Beleuchtungssystemen mit quadratischen Strukturen inklusive der Diagonalen. Nachstehend werden mehrere bevorzugte Ausführungsbeispie!e von erfindungsgemäßen Beleuchtungssystemen beschrieben, bei denen die vorstehend beschriebenen Beleuchtungsmodule 10 sowie die Verbindungselemente 30a-j zum Einsatz kommen.

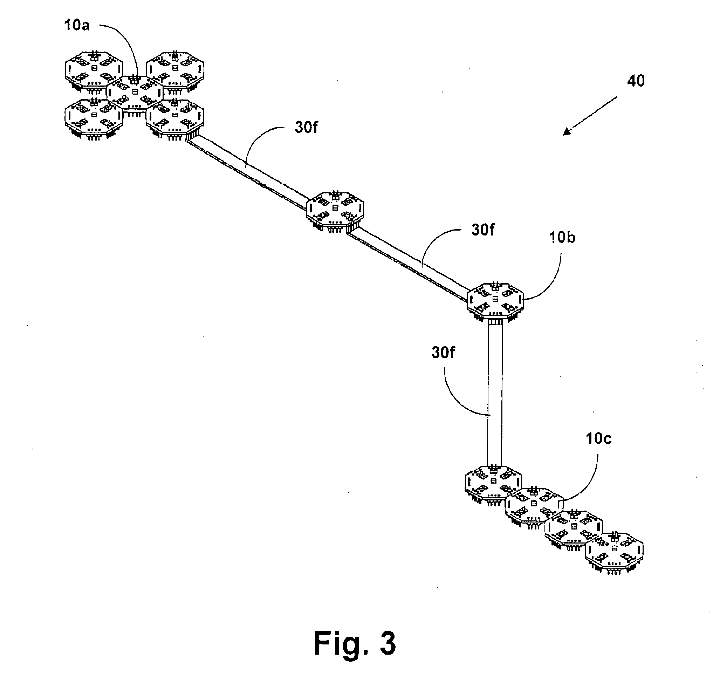

Figur 3 zeigt eine perspektivische Ansicht eines bevorzugten erfindungsgemäßen Beleuchtungssystem 40 zur Anbringung an die Decke oder die Wand eines Raums mit insgesamt elf Beleuchtungsmodulen 10, sieben kurzen Verbindungselementen 30j und drei längeren Verbindungselementen 30f. Wie vorstehend bereits beschrieben, ist es mittels der kurzen Verbindungselemente 30j möglich, mehrere Beleuchtungsmodule 10 in anstoßender Beziehung miteinander in Form einer Fläche anzuordnen. Dies lässt sich beispielsweise der kreuzförmigen Struktur aus fünf aneinander anstoßenden Beleuchtungsmodulen am linken Ende des Beleuchtungssystems 40 von Figur 3 sowie der länglichen Struktur aus vier aneinander anstoßenden Beleuchtungsmodulen am rechten Ende des Beleuchtungssystems 40 von Figur 3 entnehmen. Die kreuzförmige Struktur aus fünf aneinander anstoßenden Beleuchtungsmodulen ist über drei Verbindungselemente 30f und zwei Beleuchtungsmodule mit der der länglichen Struktur aus vier aneinander anstoßenden Beleuchtungsmodulen verbunden. Zur Befestigung des in Figur 3 dargestellten Beleuchtungssystems 40 an die Decke eines Raumes kann es beispielsweise ausreichend sein, die mit den Bezugsziffern 10a, 10b, 10c in Figur 3 gekennzeichneten Beleuchtungsmodule über Magneten oder andere geeignete Befestigungseinrichtungen an der Decke zu befestigen.

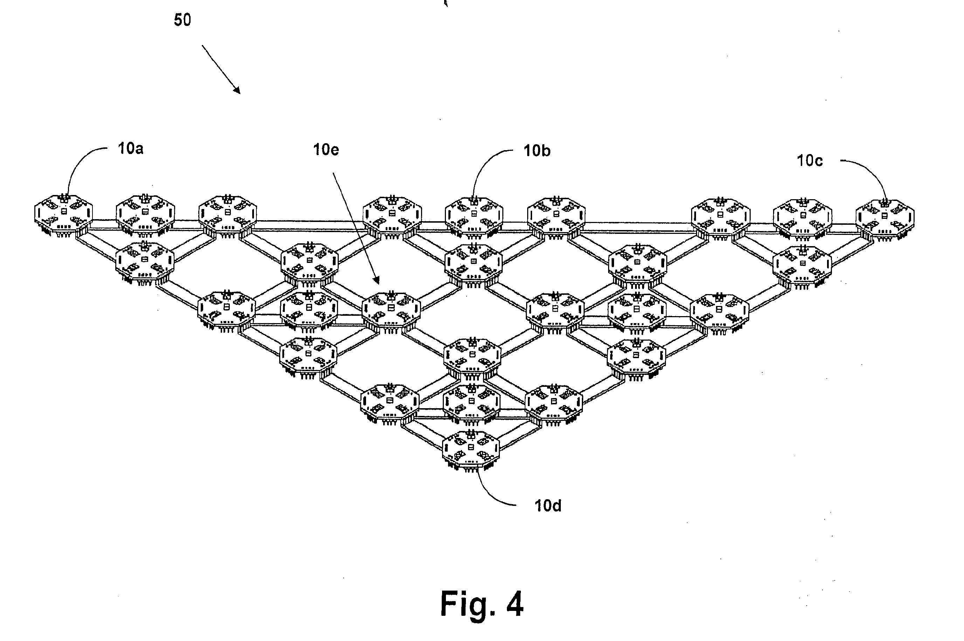

Figur 4 zeigt eine perspektivische Ansicht eines weiteren bevorzugten erfindungsgemäßen Beleuchtungssystem 50 zur Anbringung an die Decke oder die Wand eines Raums. Das Beleuchtungssystem 50 weist beispielhaft 27 Beleuchtungsmodule 10 sowie eine Vielzahl von Verbindungselementen 30a-j zur Verbindung der Beleuchtungsmodule auf. Zur Befestigung des in Figur 4 dargestellten Beleuchtungssystems 50 an die Decke eines Raumes kann es beispielsweise ausreichend sein, die mit den Bezugsziffern 10a, 10b, 10c, 10d in Figur 4 gekennzeichneten Beleuchtungsmodule, die am Rand des Beleuchtungssystems 50 angeordnet sind, über Magneten oder andere geeignete Befestigungseinrichtungen an der Decke zu befestigen. Anhand von Figur 4 lässt sich gut erkennen, dass bei einem erfindungsgemäßen Beleuchtungssystem ein Beleuchtungsmodul über mehr als ein Verbindungselement mit anderen Beleuchtungsmodulen verbunden sein kann. Beispielsweise ist das Beleuchtungsmodul 10e über fünf verschiedene Verbindungselemente mit fünf verschiedenen benachbarten Beleuchtungsmodulen verbunden.

Die Figuren 5a und 5b zeigen eine perspektivische Ansicht sowie eine Detailansicht eines Ausschnitts eines weiteren bevorzugten erfindungsgemäßen Beleuchtungssystem 60 zur Anbringung an die Decke eines Raums. Wie die erfindungsgemäßen Beleuchtungssysteme 40, 50, die in den Figuren 3 und 4 dargestellt sind, umfasst das Beleuchtungssystem 60 mehrere Beleuchtungsmodule, die mittels einer Vielzahl von Verbindungselementen miteinander verbunden sind. Zusätzlich sind bei dem Beleuchtungssystem 60 drei Beleuchtungsmodule, nämlich die Beleuchtungsmodule 10a, 10b und 10c, mit weiteren Leuchtmitteln versehen, und zwar den Leuchtmitteln 14a, 14b und 14c. Bei den Leuchtmitteln 14a, 14b und 14c handelt es sich um LED, die jeweils in einem halbkugelförmigen Gehäuse untergebracht sind. Die Vorderseite des Gehäuses wird durch eine Linse ausgebildet, die das von der LED emittierte Licht abbildet. Die Rückseite des halbkugelförmigen Gehäuses wird vorzugsweise durch ein Kühlelement ausgebildet, das im Betrieb die durch die LED erzeugte Wärme abführt. Das Kühlelement kann beispielsweise aus einer Vielzahl von Kühlrippen bestehen.

Wie sich dies am besten der Figur 5b entnehmen lässt, sind die Leuchtmittel 14a, 14b und 14c vorzugsweise an den jeweiligen Beleuchtungsmodulen 10a, 10b und 10c aufgehängt. Dabei erfolgt die Aufhängung jeweils über zwei an den Seiten des Gehäuses eines Leuchtmittels 14a, 14b und 14c befestigte Leitungen bzw. Litzen (z.B. die Kabelschnüre 23 und 24 in Figur 5b). Die Leitungen dienen somit zum einen zur stabilen mechanischen Aufhängung und zum anderen zur Zuführung von Strom und Steuerungsdaten zu einem Leuchtmittel 14a, 14b und 14c. Vorzugsweise bildet eine Leitung an ihrem oberen Ende eine elektrisch leitfähige Schlaufe aus, die in eine der in der Trägerplatte 12 eines Beleuchtungselements definierten Aussparungen 16a-d eingebracht und an einem dort ausgebildeten Zapfen aufgehängt werden kann. Dabei sind die Aussparungen bzw. Öffnungen 16a-d derart ausgestaltet, dass bei der Aufhängung einer Leitung die elektrisch leitfähige Schlaufe in Berührung mit der Innenwand der jeweiligen Aussparung bzw. Öffnung 16a-d kommt, die ebenfalls elektrisch leitfähig ist und mit der Leistungselektronik 22 eines Beleuchtungsmoduls in Verbindung steht. Aufgrund dieser Ausgestaltung ist es möglich, dem Leuchtmittel 14a, 14b und 14c eines Beleuchtungsmoduls sowohl Strom als auch Steuerungsdaten zuzuführen. Der Fachmann wird erkennen, dass es aufgrund der Ausgestaltung der Trägerplatte des Beleuchtungsmoduls mit insgesamt vier Aussparungen bzw. Öffnungen 16a-h möglich ist statt einer auch zwei Leuchtmittel an der Trägerplatte eines Beleuchtungsmoduls anzuhängen.

Bei den erfindungsgemäßen Beleuchtungssystem sind die Zuleitungen zu den Leuchtmitteln vorzugsweise kurzschlussfest, so dass bei einem Kurzschluss in den Zuleitungen zu den Leuchtmitteln maximal ein Leuchtmittel ausfällt. Das restliche Beleuchtungssystem funktioniert ohne Einschränkungen weiter. Ferner sind die erfindungsgemäßen Beleuchtungssysteme vorzugsweise so ausgestaltet, dass bei der Montage der Beleuchtungsmodule an der Decke oder der Wand eines Raums nicht auf die Polarität geachtet werden muss. Die Verbindungselemente sind vorzugsweise so ausgestaltet, dass ein Verpolen nicht möglich ist. Die Einspeisung von Strom erfolgt vorzugsweise über ein speziell ausgestaltetes Beleuchtungsmodul, das direkt oder ggf. über einen Transformator an die Netzspannung angeschlossen werden kann. Ab einer gewissen Größe des Beleuchtungssystems kann es vorteilhaft sein, weitere Einspeisungspunkte vorzusehen, d.h. Strom von einem Stromnetz über mehr als ein ggf. entsprechend ausgestaltetes Beleuchtungsmodul einzuspeisen.

Die vorstehend beschriebenen erfindungsgemäßen Beleuchtungssysteme 40, 50, 60 umfassen vorzugsweise ferner eine Steuereinheit (nicht dargestellt), die es ermöglicht, die Leuchtmittel der Beleuchtungsmodule eines Beleuchtungssystems anzusteuern. Dabei ist die Steuereinheit derart ausgestaltet und die Verbindungselemente zwischen den Beleuchtungsmodulen der Beleuchtungssysteme sind derart konfiguriert, dass die Steuereinheit die Leuchtmittel einzelner Beleuchtungsmodule, einer Untermenge der Beleuchtungsmodule und/oder aller Beleuchtungsmodule ansteuern kann, d.h. beispielsweise an- und ausschalten, die Lichtstärke steigern oder senken und dergleichen. Das "Abdimmen" und/oder andere Funktionen der Leuchtmittel eines Beleuchtungsmoduls kann zusätzlich oder alternativ dadurch erfolgen, dass eine bestimmte Stelle des Beleuchtungsmoduls berührt wird, an der ein Sensor vorgesehen ist, der in Reaktion auf die Berührung die gewünschte Funktion durchführt, beispielsweise das Leuchtmittel des betreffenden Beleuchtungsmoduls abdimmt.

Die Fähigkeit der Steuereinheit, einzelne Beleuchtungsmodule direkt anzusteuern, ist insbesondere bei der Verwendung von Beleuchtungsmodulen interessant, die Licht mit unterschiedlichen Farben aussenden (beispielsweise RGB-Beleuchtungsmodule). Dabei ermöglicht die Steuereinheit eine frei konfigurierbare Beleuchtungssituation, die sich dem Benutzer und den äußeren Bedingungen, beispielsweise dem Tageslicht, anpasst. Die Beleuchtungssituation könnte sich der Bewegung bzw. dem Aufenthaltsort des Benutzers anpassen. Hierzu kann das erfindungsgemäße Beleuchtungssystem entsprechende Sensoren zur Erfassung von Bewegungen umfassen.

Die Steuereinheit kann beispielsweise als Bus-System, insbesondere als ein Feld-Bus-System ausgestaltet sein. Diese Art der Vernetzung der Beleuchtungsmodule des Beleuchtungssystems ist kostengünstig und zuverlässig. Die Feld-Bus-Vernetzung bietet darüber hinaus die einfache Möglichkeit von Erweiterungen des Beleuchtungssystems durch Hinzufügung weiterer Beleuchtungsmodule und Verbindungselemente, die an das Bus-System problemlos anschließbar sind. Vorzugsweise werden in einem Bus-System nicht nur Steuerungsinformationen an die Beleuchtungsmodule übertragen, sondern es wird darüber hinaus die Energie- bzw. Stromversorgung der einzelnen Beleuchtungsmodule sichergestellt. Für die Anbindung in ein eventuell vorhandenes Hausbussystem, wie z.B. Insta-Bus oder DALI, können auch Gateways eingesetzt werden.

Sofern die Steuereinheit eine externe Schnittstelle aufweist, können an das Beleuchtungssystem externe Geräte, wie beispielsweise eine Audioquelle, angeschlossen oder das Beleuchtungssystem in Kommunikationsnetzwerke, wie beispielsweise ein LAN und/oder das Internet, eingebunden werden, so dass die Steuerung des erfindungsgemäßen Beleuchtungssystems beispielsweise über einen Computer eines LANs erfolgen kann.

Anhand der vorstehend beschriebenen unterschiedlichen Ausführungsformen erfindungsgemäßer Beleuchtungssysteme 40, 50, 60 erkennt der Fachmann, dass das erfindungsgemäße Beleuchtungssystem wächst, sich mit den Wünschen und Bedürfnissen des Benutzers verändert, und es dem Benutzer ermöglicht, z.B. auf räumliche Veränderungen und damit verbundene neue Anforderungen zu reagieren und das Beleuchtungssystem durch zusätzliche Beleuchtungsmodule und Verbindungselemente entsprechend zu erweitern oder auch ein bestehendes größeres Beleuchtungssystem in zwei oder mehr kleinere Beleuchtungssysteme aufzuspalten. Beispielsweise kann durch Umbau aus einer großen Deckenleuchte eine Serie mehrerer Wandleuchten entstehen.

Das erfindungsgemäße Beleuchtungssystem stellt ein intelligentes Raumsystem dar. Dieses Raumsystem ist dazu in der Lage, den Benutzer mit langsam steigender Raumhelligkeit und Musik zu wecken, die über einen eingebauten Lautsprecher ausgegeben wird. Dabei werden die Helligkeit und Lichtfarbe an die entsprechende Tagessituation angepasst: morgens hätte man beispielsweise einen hohen Blauanteil, abends einen hohen Rotanteil. Der Benutzer könnte sich an den eingebauten Displays z.B. über News oder das aktuelle Wetter informieren. Dabei könnten die Displays auch als Steuerungs-Schnittstelle zwischen dem Benutzer und dem Beleuchtungssystem dienen. Dem erfindungsgemäßen modularen Beleuchtungssystem sind damit kaum Grenzen gesetzt.

## Patentansprüche

1. Modulares Beleuchtungssystem (40; 50; 60), umfassend:
eine Vielzahl von Beleuchtungsmodulen (10), die jeweils eine Trägerplatte (12) sowie wenigstens eine erste Schnittstelle (20a-h) zur Strom- und Signalleitung umfassen, wobei wenigstens ein Beleuchtungsmodul (10) mit Leuchtmitteln (14) versehen ist; und
eine Vielzahl von länglichen Verbindungselementen (30a-j), die an ihren jeweiligen Enden eine zweite Schnittstelle umfassen;
wobei die zwei zweiten Schnittstellen an den jeweiligen Enden eines Verbindungselements (30a-j) derart mit den jeweiligen ersten Schnittstellen (20a-h) von zwei Beleuchtungsmodulen (10) verbunden werden können, dass eine Strom- und Signalleitung zwischen den durch ein Verbindungselement miteinander verbundenen Beleuchtungsmodulen ausgebildet wird.

2. Modulares Beleuchtungssystem nach Anspruch 1, wobei es sich bei den Leuchtmitteln (14) um wenigstens eine LED und/oder eine OLED handelt.

3. Modulares Beleuchtungssystem nach Anspruch 1, wobei die Trägerplatten (12) von einigen der Beleuchtungsmodule die Form eines ebenen regelmäßigen Dreiecks, Vierecks, Sechsecks oder Achtecks oder eine Kreisform aufweisen.

4. Modulares Beleuchtungssystem nach Anspruch 1, wobei einige der Verbindungselemente (30j) eine Länge aufweisen, die es erlaubt zwei Beleuchtungsmodule in anstoßender Beziehung miteinander zu verbinden.

5. Modulares Beleuchtungssystem nach Anspruch 1, wobei einige der Verbindungselemente (30a-j) eine erste Länge L1 aufweisen und einige der Verbindungselemente (30a-j) eine zweite Länge L2 aufweisen, wobei sich die erste Länge L1 zu der zweiten Länge L2 ungefähr wie 1/√2 verhält.

6. Modulares Beleuchtungssystem nach Anspruch 1, wobei die Trägerplatten (12) von einigen der Beleuchtungsmodulen (10) die Form eines ebenen regelmäßigen Achtecks aufweisen und entlang ihrer acht Umfangsseiten mit acht ersten Schnittstellen versehen sind.

7. Modulares Beleuchtungssystem nach Anspruch 1, wobei es sich bei der wenigstens einen ersten Schnittstelle (20a-h) um einen vorzugsweise 4-poligen Pin-Header-Stecker und bei der zweiten Schnittstelle um eine dazu passende vorzugsweise 4-polige Kontaktbuchse handelt.

8. Modulares Beleuchtungssystem nach Anspruch 1, wobei in der Trägerplatte (12) eines Beleuchtungsmoduls (10) wenigstens eine Öffnung definiert ist und die Leuchtmittel (14) dieses Beleuchtungsmoduls (10) in diese Öffnung gehängt oder gesteckt sind.

9. Modulares Beleuchtungssystem nach Anspruch 1, ferner umfassend eine Steuereinheit, die dazu konfiguriert ist, die Leuchtmittel einzelner Beleuchtungsmodule (10), einer Untermenge der Beleuchtungsmodule und/oder aller Beleuchtungsmodule anzusteuern.

10. Modulares Beleuchtungssystem nach Anspruch 9, wobei es sich bei der Steuereinheit um ein Bus-System handelt.
